# EUROPEAN PATENT APPLICATION

(11) **EP 3 671 234 A1**
(43) Date of publication of application: **24.06.2020**
(21) Application number: 18460077.3
(22) Date of filing: 20.12.2018
(51) Int. Cl.: G01R 31/02, H02M 3/156

(54) **SWITCHED-MODE POWER SUPPLY**

(71) Applicant: Lug Light Factory Sp. z o.o., 65-127 Zielona Góra (PL)
(72) Inventor: Lewandowski, Wojciech, 65-124 Zielona Góra (PL); Wilczynski, Arkadiusz, 65-120 Zielona Góra (PL); Awramik, Roman, 66-008 Swidnica (PL); Szajdecki, Andrzej, 66-004 Zielona Góra (PL); Kramarski, Sylwester, 65-941 Zielona Góra (PL)
(74) Representative: Gornicki, Pawel

(57) **Abstract**

The subject of the invention is a switched-mode power supply comprising, before the output step, a system for measuring degradation of the electrolytic capacitor capacity that consists of a system for measuring the ripple voltage across the capacitor (K), frequency filter (10) that separates the useful signal containing information about the degree of degradation of the capacitor from noise signals, which is connected to the system for adjusting the level of voltage (11) to the values that can be measured with analogue methods or a microcomputer, which is connected to a microcomputer (12) with data memory and a communication system (15), which, in turn, is connected to a system for measuring the output power of the power supply (13) and a temperature sensor (14).

## Description

The subject of the invention is a switched-mode power supply comprising a system for measuring the degradation of an electrolytic capacitor, which can be used in all power supply systems equipped with electrolytic capacitors.

The invention can be used wherever servicing of the equipment is difficult due to their location and accessibility, as well as when a long-term, reliable operation of equipment is required and it is advisable to avoid serious power supply failure and/or modules supplied by it. Desired is then a possible failure warning system, as well as a supporting system for planning service works.

Currently produced power supply systems, in addition to units responsible for energy conversion are equipped with processors communicating with the master system in order to manage the parameters of power supply systems. In all power supply systems the most unreliable and susceptible to ageing parts are electrolytic capacitors. There are known measuring systems to assess the degree of degradation of the electrolytic capacitors based on the measurement of the equivalent series resistance (ESR), but so far have not been used in power supply systems.

The solutions of the prior art, and in particular on industrial power supply, power supply devices for Internet of Things (IoT), or power supplies for lighting systems do not have self-diagnostic systems, allowing for signalling the upcoming power supply failure as a result of degradation of an energy storage capacitor.

Known power supplies are most common in three configurations: single power supply, two-level power supply or a three-level power supply.

Single power supply consists of a rectifier bridge with a set of EMI filters, energy storage capacitor, control system for the operation of energy conversion and the output filter.

Two-level power supply consists in the first level a PFC system (power factor correction), consisting of a rectifier bridge with EMI filters, semiconductor switches with inductors responsible for energy conversion in the power supply, an energy storage capacitor, the control system for switches operation performing the PFC function. The second level consists of a voltage control or output current system, consisting of semiconductor switches and inductors, a control system for the operation of transistor switches and the output filters system.

Three-level power supply, in the first level comprising of PFC system consisting of: rectifier bridge including a EMI filters system, an energy storage capacitor, semiconductor switches with inductors, control system for the operation of transistor switches. The second level consists of a voltage level alignment system with semiconductor switches system with inductors and the system controlling the operation semiconductor switches. The third level comprises the control system consisting of semiconductor switches with inductors, control system for the adjustment of output parameters, and an output filter.

The configurations differ substantially in stability and quality of the final power supplied to the receiver systems, but are all equally limited by the lifetime and reliability of the filter capacitor.

In any configuration, the electrolytic capacitor in the first level of the power supply constituting the main power source for further levels of the power supply or directly to the energy receiver systems is a source of ripples that determines the ripples of the output signal. Degradation of the capacitor is a basic limitation of the currently produced power supply systems lifetime. Damage to the capacitor in the power system leads to incorrect operation or failure of the equipment.

The purpose of the invention was to design a power supply equipped with a system for diagnosing the condition of the power supply by monitoring the effects of degradation of the most sensitive part of the power supply system, which is the electrolytic capacitor.

This purpose was achieved by designing a power supply equipped with a control system for degradation of the capacitor through measuring the ripple voltage thereon during normal operation, taking account of the power supply power load and the ambient temperature. Knowing the values of ripple voltage on a new capacitor, its initial capacity, output power, temperature, and current value of the ripple voltage at the same output power and temperature, allows to determine the current capacity of the capacitor. On the basis of the change in capacitance of the capacitor, its degree of degradation is assessed. The control system for degradation of the capacitor archives and analyses the measurement data and informs the user of the degree of degradation of the capacitor and the current condition of the power system, using the idea of Internet of Things (IoT).

Switched-mode power supply according to the invention comprising a rectifier bridge with a set of EMI filters, energy storage capacitor, control system for the operation of the energy conversion system and an output filter is characterised in that the power circuit, before the output stage there is a built in system for measuring degradation of the capacitor, which consists of a system for measuring the ripple voltage across the capacitor, frequency filter that separates the useful signal containing information about the degree of degradation of the capacitor from noise signals, which is connected to the system for adjusting the level of voltage to the values that can be measured with analogue methods or a microcomputer, which is connected to a microcomputer with data memory and a communication system, which, in turn, is connected to a system for measuring the output power of the power supply and a temperature sensor. Microcomputer compares the measured ripple voltage with the value measured at the start-up of a new power supply, taking into account power consumption, voltage, current and temperature of the system. On this basis, it estimates the current value of the capacity and degree of degradation of the capacitor. The current value of ripples is stored in non-volatile memory of the microcomputer and can be sent to the master system, collecting the measured data via the communication system.

Preferably, the switched-mode power supply according to the invention is a single, two-level or three-level power supply.

It is particularly advantageous that the frequency filter of the system for measuring ripple voltage across the capacitor filters signals in the frequency range from 50 to 150 Hz.

It is particularly advantageous that the power supply comprises a second circuit to measure the capacitor discharge ripple voltage, operating in the frequency range 50 - 150 kHz.

It is particularly advantageous that the microcomputer compares the measured voltage of ripples with the value measured at start-up of new power supply, taking into account the parameters supplied by the measurement system for output power of the power supply and temperature sensor.

It is particularly advantageous that the current ripple values are stored in non-volatile cache of the measurement system for degradation of the capacitor.

It is particularly advantageous that the external communication system of the system for measuring the ripple voltage across the capacitor, sends information about the power supply condition to the user.

Below, the chart shows the results of checking changes of ripple voltage as a function of the capacitor capacitance in a two-step power supply. The solid line shows the results of measurements taken on the physical device, and the dotted line shows the results of mathematical simulation.

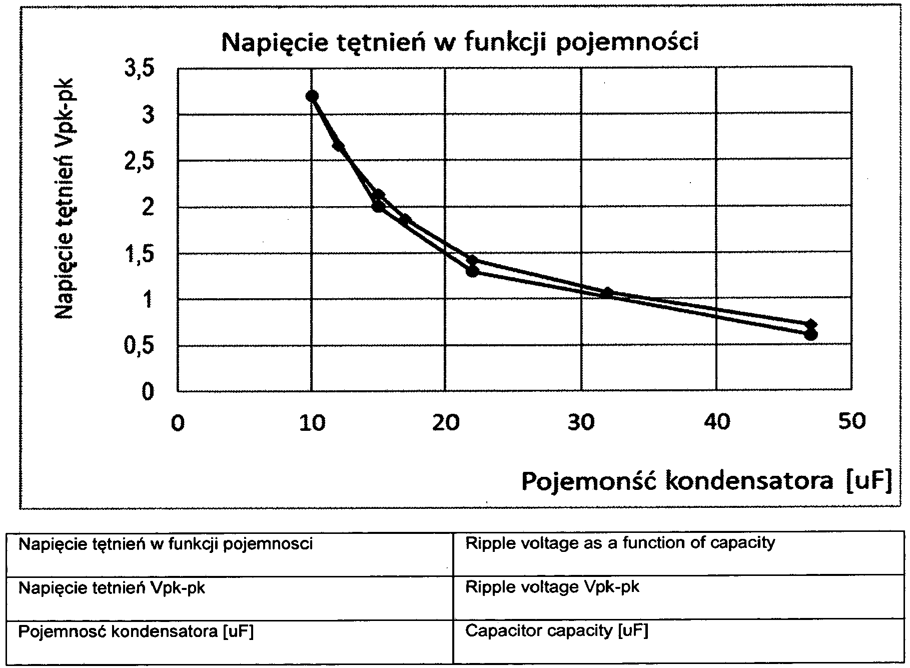

The solution according to the invention is simple and inexpensive to implement. The advantageous result of this solution according to the invention is obtaining up to date information on the condition of the monitored device, and on this basis, predicting a possible failure of the device, and planning maintenance according to the needs arising from the wear of the power supply.

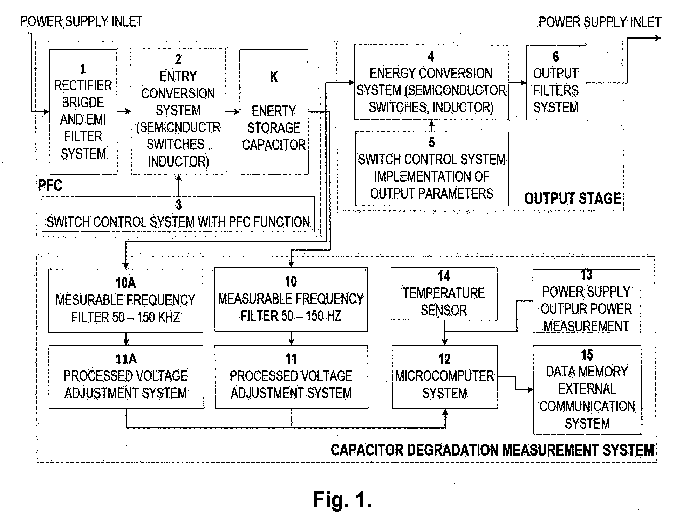

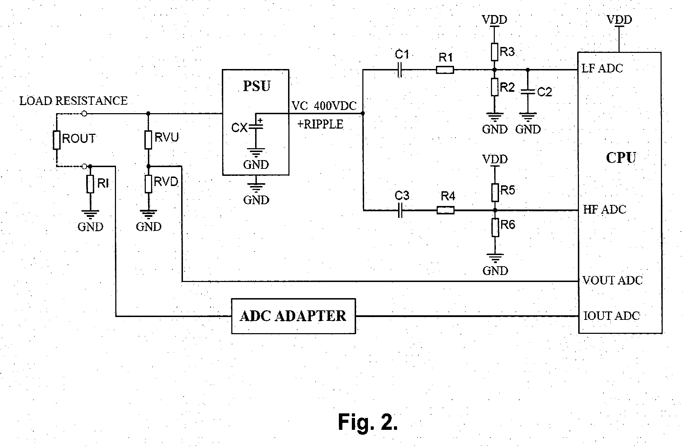

The invention is illustrated in the accompanying drawings, in which: Fig. 1 is a block diagram of a two-step power supply with a measuring system for degradation of the capacitor, and Fig. 2 shows a detailed diagram of the system for measurement of degradation of the capacitor.

The power supply according to the invention has the EMI filter system at the inlet for reducing EMI and rectifier bridge **1.** Two-half rectified voltage is supplied to the energy conversion system **2** which main elements are the semiconductor switches with inductors for energy storage. The control system for switches for active PFC **3** measures voltage of power supply and controls cycles of switching on and off the switches, with frequencies from 20 kHz to 200 kHz so as to effectively and repeatedly store and discharge energy in the inductors coupled with switches **2.** Energy stored in the power conversion system **2** is used to charge the storage capacitor **K** which is a source of voltage for the next level of the power supply. Voltage on the capacitor **K** shows ripples inversely proportional to the used capacity and proportional to the capacitor load through the second level of the power supply system. Then voltage is taken from the capacitor **K** and processed in a conversion system 4 to useful current signal by charging and discharging the inductance constituting an element of the energy conversion system **4** . Control system **5** is responsible for the correct logic of switch control in system **4**, which measures the output signal value and properly impacts the operation of the energy conversion system **4.** Typical operating frequencies at this point are in the range from 20kHz to 200kHz. Finally, useful energy as voltage, current or power is filtered in the output filter system **6**. Capacitor **K** is also connected to the system for measuring and/or control of degradation of the capacitor, comprising: frequency filters **10 and 10A** which separate the useful signal containing information about the condition of degradation of the capacitor from noise signals, the filters are further connected to the system adjusting voltage levels **11 and 11A** respectively, to the values possible to measure with analogue methods or a microcomputer. Microcomputer 12 compares the measured voltage of ripples with the value measured at start-up of new power supply, taking into account the parameters provided by the measurement system for output power of the power supply 13, such as: consumed power, voltage or current, and system operating temperature measured by the temperature sensor **14.** On this basis, the current value of the capacity and the degree of degradation of the capacitor **K** are estimated. The current value of ripples is archived in non-volatile memory and can be sent to the master system, collecting measurement data via communication system **15**.

Detailed diagram of the measurement system for degradation of the capacitor is shown in Fig. 2 The power supply unit (PSU) comprises a monitored capacitor **Cx,** from which voltage is transmitted to the ripple measurement system, which consists of two measuring circuits. The first circuit consists of elements **C1**, **C2**, **R1**, **R2**, **R3** is a system for cutting off a DC component with a band-pass filter and voltage divider, which adjusts the signal level to the processing range of the ADC. The filter is selected so as not to reduce AC voltage of a frequency of 50 150 Hz, comprising a frequency of ripples 100Hz. The value of the measured voltage is analysed by a microcomputer **µC**, which allows to detect the degree of degradation of the capacitor **Cx** by comparing the level of ripple voltage to the values recorded at the commissioning of a new power supply. The second measurement circuit, comprising high-pass filter **C3** (50-150kHz) and a voltage divider (**R4**, **R5**, **R6**) allows to estimate change in series resistance (ESR) of the capacitor **Cx**.

Output parameters of the power supply are determined by taking a measurement in two subsequent measuring circuits. The first one is used to determine the value of output current of the power supply by measuring the voltage drop across the measurement resistor **RI** which is then amplified in the ADC adapter system to a value of its processing to digital form in the analogue-digital converter of the microcomputer **µC**. A second measuring circuit is used for measuring the output voltage of the power supply. The measurement is carried out by supplying to the input of the next converter of the analogue-digital microcomputer voltage obtained by dividing the output voltage of the power supply by means of a resistance voltage divider composed of resistors **RVU** and **RVD.** Such obtained digital values allow determination of current, voltage and output power of the power supply, as a result of the calculations performed in the microcomputer, taking into account the known values of the measuring shunt **RI** and the degree of division in the divider **RVU, RVD**.

Ripple voltage measurements analysis in relation to the value measured at the start-up of a new power supply, taking into account the measurement of temperature and output power, allows for reliable assessment of the degree of wear of the most critical part of equipment - electrolytic capacitor. With data collected in a microcomputer, the system is scalable without increasing fixed costs.

## Claims

1. Switched-mode power supply comprising a rectifier bridge with a set of EMI filters, energy storage capacitor, control system for the operation of the energy conversion system and an output filter is **characterised in that** the power supply unit, before the output stage, there is a built in system for measuring degradation of the capacitor, which consists of a system for measuring the ripple voltage across the capacitor (K), frequency filter (10) that separates the useful signal containing information about the degree of degradation of the capacitor from noise signals, which is connected to the system for adjusting the level of voltage (11) to the values that can be measured with analogue methods or a microcomputer, which is connected to a microcomputer (12) with data memory and a communication system (15), which, in turn, is connected to a system for measuring the output power of the power supply (13) and a temperature sensor (14).

2. Switched-mode power supply according to Claim 1, **characterised in that** it is a single-step power supply.

3. Switched-mode power supply according to Claim 1, **characterised in that** it is a two-step power supply.

4. Switched-mode power supply according to Claim 1, **characterised in that** it is a three-step power supply.

5. Switched-mode power supply according to Claim 1, **characterised in that** the frequency filter (10) for measuring the ripple voltage across the capacitor filters signals in the frequency range from 50 to 150 Hz.

6. Switched-mode power supply according to Claim 1, **characterised in that** the filter has a second circuit for measuring the ripple voltage across the capacitor, operating in the frequency range from 50 to 150 kHz.

7. Switched-mode power supply according to Claim 1, **characterised in that** the microcomputer (12) compares the measured voltage of ripples with the value measured at start-up of new power supply, taking into account the parameters provided by the measurement system for output power of the power supply (13) and temperature sensor (14).

8. Switched-mode power supply according to Claim 1, **characterised in that** the current ripple values are stored in non-volatile cache (15) of the measurement system for degradation of the capacitor.

9. Switched-mode power supply according to Claim 1, **characterised in that** the external communication system (15) of the system for measuring the ripple voltage across the capacitor, sends information about the power supply condition to the user.
